# EUROPÄISCHE PATENTSCHRIFT

(11) **EP 3 443 589 B1**
(45) Veröffentlichungstag und Bekanntmachung des Hinweises auf die Patenterteilung: **29.09.2021**
(21) Anmeldenummer: 17720498.9
(22) Anmeldetag: 02.05.2017
(51) Int. Cl.: H01L 23/498, H01L 23/538, H01L 25/07, H01L 23/051, H02M 7/00

(54) **ELEKTRONISCHE BAUGRUPPE MIT EINEM ZWISCHEN ZWEI SCHALTUNGSTRÄGERN ANGEORDNETEN BAUELEMENT UND VERFAHREN ZUM FÜGEN EINER SOLCHEN BAUGRUPPE**
ELECTRONIC ASSEMBLY HAVING A COMPONENT BETWEEN TWO CIRCUIT CARRIERS AND METHOD FOR JOINING SUCH AN ASSEMBLY
ENSEMBLE ELECTRONIQUE COMPORTANT UN COMPOSANT ENTRE DEUX SUPPORTS DE CIRCUIT ET PROCEDE D'ASSEMBLAGE D'UN TEL ENSEMBLE

(30) Priorität: 18.05.2016 EP 16170185
(43) Veröffentlichungstag der Anmeldung: 20.02.2019
(73) Patentinhaber: Siemens Aktiengesellschaft, 80333 München (DE)
(72) Erfinder: BIGL, Thomas, 91074 Herzogenaurach (DE); HENSLER, Alexander, 90766 Fürth (DE); NEUGEBAUER, Stephan, 91058 Erlangen (DE); PFEFFERLEIN, Stefan, 90562 Heroldsberg (DE); STROGIES, Jörg, 14163 Berlin (DE); WILKE, Klaus, 12527 Berlin (DE)
(86) Internationale Anmeldenummer: PCT/EP2017/060361
(87) Internationale Veröffentlichungsnummer: WO 2017/198447

(56) Entgegenhaltungen:
- DE-A1-102014 206 608
- DE-T5-112011 101 862
- US-A- 5 759 047
- US-A- 5 904 499
- US-A1- 2005 230 809
- US-A1- 2013 214 404
- US-A1- 2014 160 691
- US-A1- 2015 262 972

## Beschreibung

Die Erfindung betrifft eine elektronische Baugruppe.

Baugruppen der eingangs angegebenen Art sind beispielsweise aus der DE 10 2014 206 601 A1 bekannt. Bei dem in dieser Veröffentlichung beschriebenen Bauelement handelt es sich um ein Leistungsbauelement, welches Kontaktflächen an seiner Oberseite und seiner Unterseite aufweist. Mit der Unterseite ist das Bauelement mit einem keramischen Substrat elektrisch leitend verbunden. Ein zweiter Schaltungsträger in Form einer Haube ermöglicht die Kontaktierung auf der Oberseite des Bauelements, wobei dieser Schaltungsträger Leitpfade aufweist, die eine Kontaktierung auf dem ersten Schaltungsträger, also auf einer anderen Ebene ermöglichen. Der haubenförmige Schaltungsträger ist daher zur Ausbildung einer Kavität geeignet, in der das Bauelement zwischen den beiden Schaltungsträgern gehalten werden kann, so dass unterschiedliche Verdrahtungsebenen entstehen. Hierbei entsteht wegen des Bedarfs der Kontaktierung auf unterschiedlichen Ebenen und auf unterschiedlichen Bauteilen ein statisch überbestimmtes System, so dass für ein zuverlässiges Kontaktieren ein Toleranzausgleich gewährleistet sein muss.

Für einen Toleranzausgleich in einer ähnlich gestalteten Baugruppe wird gemäß der DE 10 2014 206 608 A1 eine Lösung angegeben. Der haubenförmige Schaltungsträger ist gemäß dieser Veröffentlichung aus mehreren plastisch verformbaren Lagen aufgebaut, wobei zwischen diesen Lagen auch Lagen zur Verdrahtung und Kontaktierung vorgesehen sind. Dieser Schaltungsträger kann nach Montage des Bauelements auf den ersten Schaltungsträger aufgesetzt werden und während des Lötens der Kontaktierungen mit einer Fügekraft beaufschlagt werden. Dabei verformt sich der Schaltungsträger, wobei Toleranzen gleichzeitig ausgeglichen werden. Die für das Löten erforderliche Wärme sorgt gleichzeitig dafür, dass das Material des Schaltungsträgers aushärtet, wobei gleichzeitig eine abgedichtete Kavität für das Bauelement entstehen kann.

Weiterhin ist es aus der US 2011/0127663 A1 bekannt, dass Bauelemente auch in einer durch eine Haube gebildetem Kavität gegen die Außenwelt abgedichtet werden können. Die Haube wird mittels eines Dichtmittels auf dem Substrat für das Bauelement befestigt, so dass die Kavität hermetisch gegen die Umgebung abgedichtet ist. Außerdem kann ein thermisches Verbindungsmaterial zwischen dem Bauelement und der Haube vorgesehen werden, so dass diese Wärme aufnehmen kann, die in dem Bauelement entsteht.

Die US 2014/0160691 offenbart ein einfach fertigbares Halbleitermodul.

Die DE 11 2011 101 862 T2 offenbart eine elektrische Verbindungsvorrichtung, die es erleichtert, ein Verbindungsbauteil in guten Oberflächenkontakt mit einem Elektrodenbauteil während des Verbindens zu bringen.

Wie sich zeigt, sind die oben dargestellten Lösungen umso komplexer, je mehr Funktionen in die Schaltungsträger integriert werden sollen. Gleichzeitig wirft eine zuverlässige Kontaktierung aufgrund der statischen Überbestimmtheit der beschriebenen Systeme Probleme auf.

Die Aufgabe der Erfindung liegt daher darin, eine elektronische Baugruppe, bei der das Bauelement zwischen zwei Schaltungsträgern gehalten werden und elektrisch kontaktiert werden soll, dahingehend zu verbessern, dass einerseits eine zuverlässige Kontaktierung des Bauelements ermöglicht wird und andererseits eine kostengünstige Herstellung und Montage der Komponenten möglich ist.

Diese Aufgabe wird durch die Merkmale des Anspruches 1 gelöst. Durch die elastische Ausführung kann erfindungsgemäß erreicht werden, dass Maßtoleranzen und Lagetoleranzen der beteiligten Fügepartner, d. h. der beiden Schaltungsträger, dem Bauelement und Depots aus einem Fügehilfsstoff, z. B. einem Lotwerkstoff oder einem Sinterwerkstoff, dadurch ausgeglichen werden können, dass der Kontaktbereich beim Fügen in Fügerichtung und damit senkrecht zur ersten Montageseite und bevorzugt auch zur zweiten Montageseite nachgibt. Dabei kann eine Verbindung der Bauelemente oder des Bauelements mit dem ersten und/oder dem zweiten Schaltungsträger elektrisch und/oder thermisch erfolgen. Wenn im Folgenden von einem Schaltungsträger oder beiden Schaltungsträgern die Rede ist, ist damit immer der erste Schaltungsträger und der zweite Schaltungsträger bzw. einer von diesen Schaltungsträgern gemeint, wenn es nicht darauf ankommt, ob die Aussage für den ersten Schaltungsträger oder den zweiten Schaltungsträger gemacht wird.

Der Ausgleich der Toleranzen durch den elastischen Kontaktbereich, also demjenigen Bereich auf dem ersten Schaltungsträger, auf dem das Bauelement evtl. unter Zuhilfenahme eines Fügehilfsstoffs aufgesetzt ist, ist daher so wichtig, weil die elektronische Baugruppe aufgrund der Vielzahl der auszubildenden Verbindungen statisch überbestimmt ist. Deswegen müssen Toleranzen, die bei den Fügepartnern unterschiedlich groß ausfallen können, durch eine Elastizität wenigstens eines Teils der Fügepartner ausgeglichen werden. Diese Elastizität ist erfindungsgemäß am einfachsten bei dem ersten Schaltungsträger zu verwirklichen. Die Baugruppe kann einfach gefügt werden, wobei die Fügestellen vorteilhaft zuverlässig ausgebildet werden.

Erfindungsgemäß ist vorgesehen, dass der Kontaktbereich sowohl im Vergleich zum den Kontaktbereich umgebenden ersten Schaltungsträger als auch im Vergleich zum zweiten Schaltungsträger elastischer in Richtung senkrecht zur ersten Montageseite ausgeführt ist. Elastischer bedeutet mit anderen Worten, dass der Kontaktbereich zumindest in Teilbereichen, insbesondere in dessen Randbereich, mit einem geringeren Elastizitätsmodul ausgestattet ist, als der restliche erste Schaltungsträger und der zweite Schaltungsträger, wodurch die Nachgiebigkeit des Kontaktbereichs durch eine Materialeigenschaft sozusagen intrinsisch erzeugt wird. Dies erzeugt vorteilhaft einen reversiblen Toleranzausgleich, der auch beispielsweise nach einem Reparaturlöten zum Auswechseln des Bauelements erneut zum Einsatz kommen kann.

Erfindungsgemäß ist in dem Kontaktbereich das Material des ersten Schaltungsträgers auch im Vergleich zum den Kontaktbereich umgebenden Schaltungsträger abgedünnt. Damit ist gemeint, dass die Materialdicke des Schaltungsträgers in diesem Bereich eine geringere Dicke aufweist, als in den Kontaktbereichen umgebenden Zonen des Schaltungsträgers. Auf diese Weise wird in dem Kontaktbereich eine größere Elastizität erzeugt, was vorteilhaft durch einen einfach durchzuführenden Fertigungsschritt beispielsweise durch Fräsen oder Ätzen erreicht werden kann.

Der abgedünnte Bereich kann vorteilhaft fortgebildet werden, indem das Material des abgedünnten Bereichs in den ersten Schaltungsträger einlaminiert ist und im Kontaktbereich freigelegt ist. Als Halbzeug für die genannte Struktur kommen beispielsweise laminierte Leiterplatten in Frage, wobei eine dieser laminierten Schichten durch Freilegen als abgedünnter Bereich genutzt wird. Hierbei kann vorteilhaft ein kostengünstig zu beschaffendes, weil technisch weit verbreitetes Halbzeug zur Herstellung des ersten Schaltungsträgers verwendet werden. Das Material kann vorteilhaft Polyimid sein. Es kann eine an sich bekannte Herstellungstechnologie zur Herstellung sogenannter Flex-Starr-Leiterplatten verwendet werden, welche Teilbereiche aufweisen, die flexibel sind und Teilbereiche aufweisen, die im Vergleich dazu starr sind. Erfindungsgemäß werden die flexiblen Teilbereiche als Kontaktbereich für das Bauelement verwendet.

Gemäß einer weiteren Ausgestaltung der Erfindung kann vorgesehen werden, dass der Rand des Kontaktbereichs durch Ausnehmungen geschwächt ist. Die Schwächung des Rands des Kontaktbereichs führt dazu, dass der Kontaktbereich als Ganzes nachgibt, indem der durch Ausnehmungen mechanisch geschwächte Rand elastisch verformt wird, wenn sich der Kontaktbereich in Montagerichtung senkrecht zur ersten Montageseite verschiebt. Ausnehmungen können vorteilhaft beispielsweise durch Fräsen oder Ätzen hergestellt werden, weswegen vorteilhaft einfache und zuverlässige Fertigungsverfahren zur Verfügung stehen.

Gemäß einer speziellen Ausgestaltung der Erfindung kann vorgesehen werden, dass die Ausnehmungen aus den ersten Schaltungsträger durchbrechenden Schlitzen bestehen, wobei zwischen den Schlitzen Stege vorgesehen sind, die den Kontaktbereich mit dem restlichen ersten Schaltungsträger verbinden. Auf diese Weise bilden die Stege Biegebalken aus, die als elastischer Bereich genutzt werden können. Diese sind an ihren Enden jeweils mit dem Kontaktbereich und mit dem restlichen ersten Schaltungsträger verbunden. Da die Schlitze den Schaltungsträger durchbrechen, also mit anderen Worten Durchgangsöffnungen in dem Schaltungsträger erzeugen, ist eine Kraftanleitung jeweils nur an den Enden der Biegebalken möglich.

Vorteilhaft können die Stege Verzweigungen und/oder einen Verlauf mit mindestens einem Richtungswechsel in der Ebene der ersten Montageseite aufweisen. Hierdurch kann die Biegesteifigkeit der durch die Stege ausgebildeten Biegebalken vorteilhaft beeinflusst werden und es ist möglich, die Stege an die Geometrie des Kontaktbereichs anzupassen.

Eine weitere Ausgestaltung der Erfindung sieht vor, dass der erste Schaltungsträger in der ersten Montageseite eine Vertiefung aufweist, in der sich das Bauelement befindet. Hierdurch kann das Bauelement vorteilhaft in eine nach außen abgeschlossene Kavität eingebracht werden, die im Bereich der Vertiefung durch den ersten Schaltungsträger und den zweiten Schaltungsträger ausgebildet wird. Diese Kavität kann zusätzlich durch ein elektrisches Isoliermaterial ausgefüllt werden.

Erfindungsgemäß ist das Bauelement mit der ersten Montageseite und mit der zweiten Montageseite stoffschlüssig verbunden. Hierbei können beispielsweise Lötverbindungen oder Sinterverbindungen oder auch Klebeverbindungen zum Einsatz kommen. Die Verbindungen können zur Übertragung eines elektrischen Stroms oder auch zur Übertragung von Wärme genutzt werden.

Außerdem wird die oben angegebene Aufgabe erfindungsgemäß auch durch ein Verfahren zum Fügen einer elektronischen Baugruppe gelöst. Dieses ist dadurch gekennzeichnet, dass der erste Schaltungsträger oder der zweite Schaltungsträger mit dem Bauelement bestückt wird. Danach wird der erste Schaltungsträger mit dem zweiten Schaltungsträger gefügt. Dabei werden Verbindungen zwischen dem Bauelement und dem ersten Schaltungsträger und/oder dem zweiten Schaltungsträger ausgebildet. Hierbei entsteht eine elektronische Baugruppe, wie diese bereits vorstehend beschrieben wurde, wobei sich die angegebenen Vorteile ergeben.

Gemäß einer Ausbildung des Verfahrens kann vorgesehen werden, dass zumindest ein Teil der Verbindungen zwischen dem ersten Schaltungsträger, dem zweiten Schaltungsträger und dem Bauelement durch Sintern und/oder durch Löten ausgebildet werden. Hierdurch lassen sich vorteilhaft sehr zuverlässige Verbindungen schaffen, mit denen elektrische Ströme und/oder thermische Energie übertragen werden können.

Weiterhin kann vorteilhaft vorgesehen werden, dass bei dem Verbinden des ersten Schaltungsträgers mit dem zweiten Schaltungsträger eine Fügekraft F auf den nachgiebigen Kontaktbereich aufgebracht wird. Mittels der Fügekraft kann der Kontaktbereich im Rahmen seiner Nachgiebigkeit in Fügerichtung senkrecht zur ersten Montageseite bewegt werden, um z. B. Spalte aufgrund von Maßtoleranzen der Fügepartner zu überwinden. Auch kann auf diesem Wege die Fügekraft auf sich ausbildende elektrische Verbindungen vergrößert werden, was beispielsweise bei der Ausbildung von Sinterverbindung von Vorteil ist.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben. Es zeigen:
- Figur 1: ein Ausführungsbeispiel der erfindungsgemäßen elektronischen Baugruppe im schematischen Schnitt,
- Figur 2 bis 3: weitere Ausführungsbeispiele der erfindungsgemäßen Baugruppe, wobei jeweils nur der Kontaktbereich im Querschnitt bzw. als Aufsicht dargestellt ist und wobei diese Kontaktbereiche in einem Aufbau der Baugruppe gemäß Figur 1 vorgesehen werden können und
- Figur 4: ein Ausführungsbeispiel des erfindungsgemäßen Verfahrens jeweils in einem Fertigungszustand und im schematischen Querschnitt.

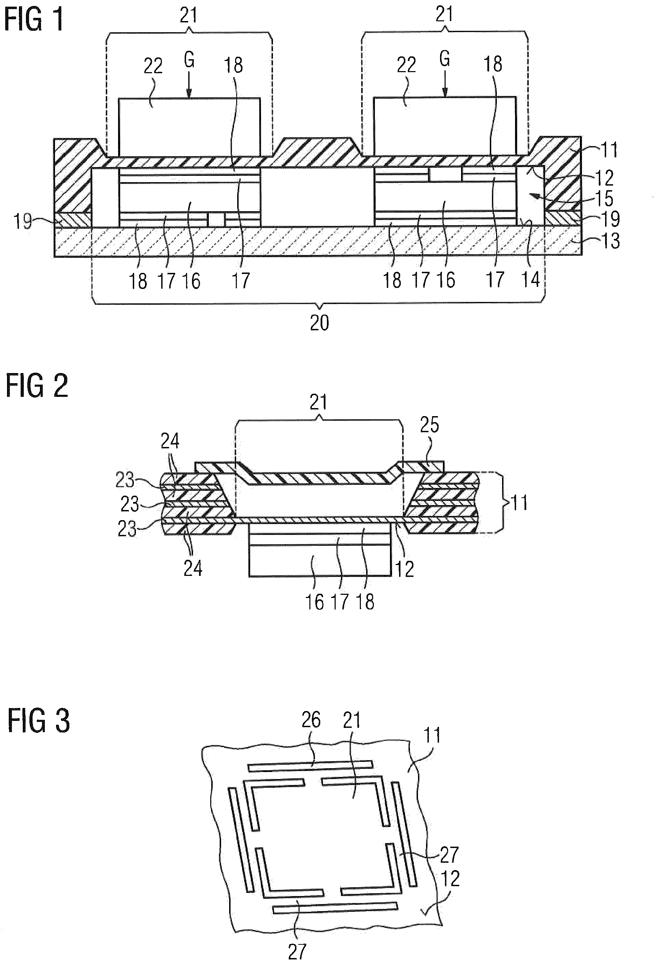

Gemäß Figur 1 ist ein erster Schaltungsträger 11 mit einer ersten Montageseite 12 aus einem Leiterplattenmaterial, beispielsweise epoxidbasierte Systeme wie FR4, und ein zweiter Schaltungsträger 13 mit einer zweiten Montageseite 14 aus einer Keramik, beispielsweise Al₂O₃, Si₃N₄ oder A1N dargestellt. Diese beiden Schaltungsträger 11, 13 bilden eine Kavität 15, in die zwei Bauelemente 16 eingesetzt ist. Die Bauelemente 16 sind über Lötverbindungen 17 jeweils mit der ersten Montageseite 12 und der zweiten Montageseite 14 verbunden. Hierfür stellen die beiden Montageseiten 12, 14 Kontaktpads 18 zur elektrischen Kontaktierung zur Verfügung. Außerdem ist der erste Schaltungsträger 11 über eine Klebeverbindung 19 mit dem zweiten Schaltungsträger 13 elektrisch leitfähig verbunden, wodurch die Kavität 15 nach außen abgedichtet wird.

Die Kavität 15 wird durch eine Vertiefung 20 in dem ersten Schaltungsträger 11 gebildet. Innerhalb dieser Vertiefung sind die Bauelemente 16 untergebracht. Für die Bauelemente 16 sind außerdem Kontaktbereiche 21 vorgesehen, die auf der Montageseite 12 die Kontaktpads 18 tragen. Die Kontaktbereiche 21 sind außerdem durch eine größere Elastizität nachgiebiger ausgestaltet als der Rest des Schaltungsträgers 11, was gemäß Figur 1 durch eine Abdünnung des Materials der Leiterplatte erreicht wird. Hieraus ergeben sich auf der der Montageseite gegenüberliegenden Seite des Schaltungsträgers 11 Vertiefungen, die den Kontaktbereich 21 definieren. In Figur 1 ist dargestellt, dass bei einer Montage beispielsweise Massestücke 22 auf die Kontaktbereiche 21 gelegt werden können, die eine Gewichtskraft G zur Unterstützung eines Zusammenfügens auf den ersten Schaltungsträger 11 ausüben.

In Figur 2 ist zu erkennen, dass der erste Schaltungsträger 11 erfindungsgemäß ein Laminat aus mehreren Lagen 23 ausgebildet ist, die in das Material 24 des Schaltungsträgers einlaminiert sind. Eine der Lagen 23 bildet erfindungsgemäß den abgedünnten Kontaktbereich 21 aus, auf dem das Kontaktpad 18 mit dem Bauelement 16 angeordnet ist. Zusätzlich kann die Abdünnung mit einer Abdeckung 25 versehen werden, um diesen Bereich nach außen zu schützen.

Gemäß Figur 3 ist der Kontaktbereich 21 durch Schlitze 26 in der Montageseite 12 von dem restlichen Schaltungsträger 11 abgetrennt. Zwischen den Schlitzen sind Stege 27 ausgebildet, welche als Biegebalken wirken, so dass hierdurch ein sehr elastischer Bereich entsteht. Die Stege verbinden außerdem den Montagebereich 21 mit dem restlichen Schaltungsträger 11. Der Montagebereich 21 steht für die Montage eines nicht dargestellten Bauelements zur Verfügung. Die Schlitze 26 sind als Durchgangsöffnungen in dem Schaltungsträger 11 ausgeführt, so dass in nicht dargestellter Weise eine Abdeckung 25 analog zur Figur 2 vorgesehen werden kann, wenn die durch die beiden Schaltungsträger 11, 13 gebildete Kavität nach außen abgedichtet sein soll.

Auch kann eine Struktur gemäß Figur 3 in einen abgedünnten Montagebereich 21 gemäß Figur 1 oder 2 eingebracht werden, um eine zusätzliche Erhöhung der Elastizität zu erreichen.

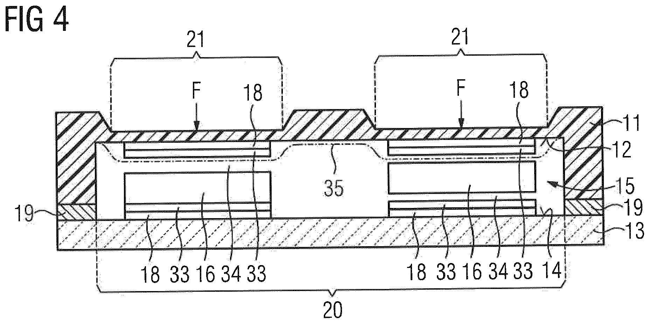

In Figur 4 ist der Montageprozess für die elektronische Baugruppe dargestellt. Es wird deutlich, dass entweder aufgrund des intendierten Fertigungsprozesses gewollt oder aufgrund von Maßtoleranzen der Fügepartner - insbesondere der beiden Schaltungsträger 11, 13, der Bauelemente 16 und von Sinterformteilen 33 - in vormontiertem Zustand der Baugruppe ein Fügespalt 34 verbleibt: Je nachdem, auf welchem der Schaltungsträger 11, 13 das Bauelement 16 vormontiert ist, entsteht der Fügespalt gegenüberliegend zum zugehörigen Sinterformteil 33 (es sind jedoch auch andere Konfigurationen denkbar) .

Um diesen Fügespalt zu überbrücken, kann nun eine Fügekraft F während des Sinterns auf den ersten Schaltungsträger 11 wirken, so dass die elastischen Kontaktbereiche 21 sich entsprechend der strichpunktiert dargestellten Biegelinie 35 verformen, wodurch die Fügespalte 34 geschlossen werden. Gleichzeitig wird durch die Fügekraft F ein genügender Druck zur Ausbildung der Sinterverbindungen mittels der Sinterformteile 33 aufgebaut (die entsprechende Fügetemperatur muss selbstverständlich auch eingehalten werden).

## Patentansprüche

1. Elektronische Baugruppe, aufweisend
• einen ersten Schaltungsträger (11) mit einer ersten Montageseite (12) für elektronische Bauelemente,
• einen zweiten Schaltungsträger (13) mit einer zweiten Montageseite (14) für elektronische Bauelemente, wobei der zweite Schaltungsträger (13) mit der zweiten Montageseite (14) der ersten Montageseite (12) des ersten Schaltungsträgers (11) zugewandt und mit diesem verbunden ist,
• mindestens ein elektronisches Bauelement (16), welches sowohl mit der ersten Montageseite (12) als auch mit der zweiten Montageseite (14) verbunden ist, wobei
das Bauelement (16) mit der ersten Montageseite (12) und mit der zweiten Montageseite (14) stoffschlüssig verbunden ist, wobei die Montageseiten (12, 14) jeweils Kontaktpads (18) zur elektrischen Kontaktierung des mindestens einen elektronischen Bauelements (16) aufweisen und
der erste Schaltungsträger (11) in einem zwischen dem ersten Schaltungsträger (11) und dem Bauelement (16) ausgebildeten Kontaktbereich (21)
• im Vergleich zum den Kontaktbereich (21) umgebenden ersten Schaltungsträger (11) und
• im Vergleich zum zweiten Schaltungsträger (13) elastischer in Richtung senkrecht zur ersten Montageseite (12) ausgeführt ist, wobei
in dem Kontaktbereich (21) das Material des ersten Schaltungsträgers (11) im Vergleich zum den Kontaktbereich (21) umgebenden Schaltungsträger (11) abgedünnt ist,
**dadurch gekennzeichnet, dass**
der erste Schaltungsträger (11) als ein Laminat aus mehreren Lagen (23) ausgebildet ist, die in das Material (24) des ersten Schaltungsträgers (11) einlaminiert sind und wobei eine der Lagen (23) den abgedünnten Kontaktbereich (21) ausbildet, auf dem das Kontaktpad (18) mit dem Bauelement (16) angeordnet ist.

2. Baugruppe nach Anspruch 1,
**dadurch gekennzeichnet,**
**dass** das Material des abgedünnten Bereiches in den ersten Schaltungsträger (11) einlaminiert ist und im Kontaktbereich (21) freigelegt ist.

3. Baugruppe nach Anspruch 2,
**dadurch gekennzeichnet,**
**dass** das Material des abgedünnten Bereiches Polyimid ist.

4. Baugruppe nach einem der Ansprüche 1 bis 3,
**dadurch gekennzeichnet,**
**dass** der Rand des Kontaktbereiches (21) durch Ausnehmungen geschwächt ist.

5. Baugruppe nach Anspruch 4,
**dadurch gekennzeichnet,**
**dass** die Ausnehmungen aus den ersten Schaltungsträger (11) durchbrechenden Schlitzen (26) bestehen, wobei zwischen den Schlitzen (26) Stege (27) vorgesehen sind, die den Kontaktbereich (21) mit dem restlichen ersten Schaltungsträger (11) verbinden.

6. Baugruppe nach Anspruch 5,
**dadurch gekennzeichnet,**
**dass** die Stege (27) Verzweigungen und/oder einen Verlauf mit mindestens einem Richtungswechsel in der Ebene des ersten Montageseite (12) aufweisen.

7. Baugruppe nach einem der voranstehenden Ansprüche,
**dadurch gekennzeichnet,**
**dass** der erste Schaltungsträger (11) in der ersten Montageseite (12) eine Vertiefung (20) aufweist, in der sich das Bauelement (16) befindet.

8. Baugruppe nach Anspruch 7,
**dadurch gekennzeichnet,**
**dass** der erste Schaltungsträger (11) und der zweite Schaltungsträger (13) eine nach außen abgeschlossene Kavität (15) ausbilden.

9. Verfahren zum Fügen einer elektronischen Baugruppe nach einem der vorangehenden Ansprüche,
**dadurch gekennzeichnet,**
**dass**
• der erste Schaltungsträger (11) oder der zweite Schaltungsträger (13) mit dem Bauelement (16) bestückt wird,
• danach der erste Schaltungsträger (11) mit dem zweiten Schaltungsträger (13) gefügt wird und
• die Verbindungen zwischen dem Bauelement und dem ersten Schaltungsträger (11) und dem zweiten Schaltungsträger (13) ausgebildet werden.

10. Verfahren nach Anspruch 9,
**dadurch gekennzeichnet,**
**dass** zumindest ein Teil der Verbindungen zwischen dem ersten Schaltungsträger (11), dem zweiten Schaltungsträger (13) und dem Bauelement (16) durch Sintern und/oder durch Löten und/oder durch einen elektrisch leitfähigen Leitkleber ausgebildet werden.

11. Verfahren nach einem der Ansprüche 9 oder 10,
**dadurch gekennzeichnet,**
**dass** bei dem Verbinden des ersten Schaltungsträgers (11) mit dem zweiten Schaltungsträger (13) eine Fügekraft F auf den elastischen Kontaktbereich (21) aufgebracht wird.

## Claims

1. Electronic assembly comprising:
• a first circuit carrier (11) having a first mounting face (12) for electronic components,
• a second circuit carrier (13) having a second mounting face (14) for electronic components, wherein the second circuit carrier (13) with the second mounting face (14) faces the first mounting face (12) of the first circuit carrier (11) and is connected thereto,
• at least one electronic component (16) that is connected both to the first mounting face (12) and also to the second mounting face (14), wherein
the component (16) is connected to the first mounting face (12) and to the second mounting face (14) in a firmly bonded manner,
wherein the mounting faces (12, 14) each have contact pads (18) so as to provide electrical contact with the at least one electronic component (16), and
the first circuit carrier (11) in a contact region (21) that is formed between the first circuit carrier (11) and the component (16) is configured
• in comparison to the first circuit carrier (11) that is surrounding the contact region (21) and
• in comparison to the second circuit carrier (13) so as to be elastic in the direction perpendicular with respect to the first mounting face (12), wherein
the material of the first circuit carrier (11) is thinner in the contact region (21) in comparison to the circuit carrier (11) that is surrounding the contact region (21), **characterized in that**
the first circuit carrier (11) is configured as a laminate having multiple layers (23) that are laminated into the material (24) of the first circuit carrier (11) and wherein one of the layers (23) forms the thinner contact region (21) on which the contact pad (18) together with the component (16) is arranged.

2. Assembly according to Claim 1,
**characterized**
**in that** the material of the thinner region is laminated into the first circuit carrier (11) and is exposed in the contact region (21).

3. Assembly according to Claim 2,
**characterized**
**in that** the material of the thinner region is polyimide.

4. Assembly according to any one of Claims 1 to 3,
**characterized**
**in that** the edge of the contact region (21) is weakened by means of cut-outs.

5. Assembly according to Claim 4,
**characterized**
**in that** the cut-outs are slits (26) that penetrate the first circuit carrier (11), wherein webs (27) that connect the contact region (21) to the remaining part of the first circuit carrier (11) are provided between the slits (26).

6. Assembly according to Claim 5,
**characterized**
**in that** the webs (27) comprise branches and/or they extend with at least one change of direction in the plane of the first mounting face (12).

7. Assembly according to one of the preceding claims,
**characterized**
**in that** the first circuit carrier (11) comprises a depression (20) in the first mounting face (12), the component (16) being positioned in said depression.

8. Assembly according to Claim 7,
**characterized**
**in that** the first circuit carrier (11) and the second circuit carrier (13) form a cavity (15) that is closed with respect to the external environment.

9. Method for joining an electronic assembly according to any one of the preceding claims,
**characterized**
**in that**
• the component (16) is fitted to the first circuit carrier (11) or the second circuit carrier (13),
• afterwards the first circuit carrier (11) is joined to the second circuit carrier (13) and
• the connections are formed between the component and the first circuit carrier (11) and the second circuit carrier (13) .

10. Method according to Claim 9,
**characterized**
**in that** at least some of the connections are formed between the first circuit carrier (11), the second circuit carrier (13) and the component (16) by means of a sintering procedure and/or by means of a soldering procedure and/or by means of an electrically conductive adhesive.

11. Method according to either one of Claims 9 or 10,
**characterized**
**in that** as the first circuit carrier (11) is connected to the second circuit carrier (13) a joining force F is applied to the elastic contact region (21).

## Revendications

1. Module électronique, comportant
• un premier support (11) de circuit ayant une première face (12) de montage de composants électroniques,
• un deuxième support (13) de circuit ayant un deuxième face (14) de montage de composants électroniques, le deuxième support (13) de circuit étant par la deuxième face (14) de montage tourné vers la première face (12) de montage du premier support (11) de circuit et y étant relié,
• au moins un composant (16) électronique, qui est relié à la fois à la première face (12) de montage et à la deuxième face (14) de montage, dans lequel
le composant (16) est relié à coopération de matière à la première face (12) de montage et à la deuxième face (14) de montage, les faces (12, 14) de montage ayant chacune des plages (18) de contact pour la mise en contact électrique du au moins un composant (16) électronique et
le premier support (11) de circuit est, dans une partie (21) de contact constituée entre le premier support (11) de circuit et le composant (16),
• par rapport au premier support (11) de circuit entourant la partie (21) de contact et
• par rapport au deuxième support (13) de circuit réalisé en étant élastique dans une direction perpendiculaire à la première face (12) de montage, dans lequel
dans la partie (21) de contact, le matériau du premier support (11) de circuit est aminci par rapport au support (11) de circuit entourant la partie (21) de contact,
**caractérisé en ce que**
le premier support (11) de circuit est constitué sous la forme d'un stratifié composé de plusieurs couches (23), qui est inséré dans le matériau (24) du premier support (11) de circuit et dans lequel l'une des couches (23) constitue la partie (21) de contact amincie, sur laquelle est montée la plage (18) de contact ayant le composant (16).

2. Module suivant la revendication 1,
**caractérisé en ce que**
le matériau de la partie amincie est inséré par laminage dans le premier support (11) de circuit et est dénudé dans la partie (21) de contact.

3. Module suivant la revendication 2,
**caractérisé en ce que**
le matériau de la partie amincie est du polyimide.

4. Module suivant l'une des revendications 1 à 3,
**caractérisé en ce que**
le bord de la partie (21) de contact est affaibli par des évidements.

5. Module suivant la revendication 4,
**caractérisé en ce que**
les évidements sont constitués de fentes (26) traversant le premier support (11) de circuit, des parties pleines (27) qui relient la partie (21) de contact au reste du premier support (11) de circuit étant prévues entre les fentes (26).

6. Module suivant la revendication 5,
**caractérisé en ce que**
les parties pleines (27) ont des bifurcations et/ou un tracé ayant au moins un changement de direction dans le plan de la première face (12) de montage.

7. Module suivant l'une des revendications précédentes,
**caractérisé en ce que**
le premier support (11) de circuit a dans la première face (12) de montage une cavité (20) dans laquelle se trouve le composant (16) .

8. Module suivant la revendication 7,
**caractérisé en ce que**
le premier support (11) de circuit et le deuxième support (13) de circuit constituent une cavité (15) fermée vers l'extérieur.

9. Procédé de jonction d'un module électronique suivant l'une des revendications précédentes,
**caractérisé en ce que**
• on équipe le premier support (11) de circuit ou le deuxième support circuit du composant (16)
• on joint le premier support (11) de circuit au deuxième support (13) de circuit,
• on constitue les liaisons entre le composant et le premier support (11) de circuit et le deuxième support (13) de circuit.

10. Procédé suivant la revendication 9,
**caractérisé en ce que**
l'on constitue au moins une partie des liaisons entre le premier support (11) de circuit, le deuxième support (13) de circuit et le composant (16) par frittage et/ou par brasage et/ou par une colle conductrice de l'électricité.

11. Procédé suivant l'une des revendications 9 ou 10,
**caractérisé en ce que**
**en ce que** lors de la liaison du premier support (11) de circuit au deuxième support (13) de circuit, on applique une force F de jonction à la partie (21) de contact élastique.
